# EUROPEAN PATENT APPLICATION

(11) **EP 4 578 731 A1**
(43) Date of publication of application: **02.07.2025**
(21) Application number: 23220520.3
(22) Date of filing: 28.12.2023
(51) Int. Cl.: B60Q 1/00, B60Q 1/26, B60Q 1/50, F21S 43/14, F21S 43/15, F21S 43/237, F21S 43/239, F21S 43/243, F21S 43/245, F21S 43/20, F21S 43/40, G09F 9/33, H01L 25/075, H01L 27/15, H01L 25/16

(54) **LIGHTING ASSEMBLY**

(71) Applicant: Marelli Automotive Lighting Italy S.p.A., 10078 Venaria Reale (TO) (IT)
(72) Inventor: SACCÀ, Alessandro, 33028 Tolmezzo, Udine (IT); ANTONIPIERI, Michele, 33028 Tolmezzo, Udine (IT); LEONE, Fabio, 33028 Tolmezzo, Udine (IT)
(74) Representative: Chimini, Francesco

(57) **Abstract**

A lighting assembly, in particular for a car headlight (40), comprises a display (10), an array of first point light sources (12) suitable for generating a first light effect on the display (10), and at least one optical element (14) placed alongside the display (10) and suitable for generating a second light effect. The optical element (14) comprises at least a second light source (16) and at least one optical structure (18) coupled to the at least a second light source (16) and configured to form a plurality of light-emitting points (20) which, when the second light source (16) is activated, generate the second light effect in combination. The distance (D1; D2) between adjacent light-emitting points (20) of at least one portion of said plurality of light-emitting points is substantially uniform and substantially equal to the distance (P1; P2) between the first point light sources (12).

## Description

The present invention relates to a lighting assembly, in particular for car light clusters.

In some applications, e.g., in car light clusters, it is known to place a mini-LED array display alongside one or more lighting devices of more conventional type. Since the mini-LED array display has a very high resolution by virtue of the small size and very small distance between the mini-LEDs, it is used indeed to produce images, logos, or other information. Instead, the lighting devices alongside the display, for example made of LEDs, light guides, and/or reflectors, are used to generate simpler lighting effects, for example, in the case of the light cluster, lighting and signal light functions, e.g., brake and tail lights.

One limitation of these combinations of lighting devices lies precisely in the different rendering of the light effect in terms of resolution and definition. Indeed, especially when the two different lighting devices are placed side-by-side, the effect of unevenness, i.e., the interruption, between the two light effects can be clearly perceived. In a context such as that of premium cars, in which the search for increasingly distinctive and defined lighting effects is exacerbated, such a discontinuity is poorly tolerated.

Therefore, there is an increasing need to make the overall light effect produced by the combination of a display, e.g., a mini-LED array, and LED lighting elements and related optical devices as uniform and continuous as possible, as described above.

Thus, it is the object of the present invention to suggest a lighting assembly of the aforesaid type, in particular for car light clusters, but capable of solving the drawbacks of lighting systems according to the prior art.

Such an object is achieved by a lighting assembly according to claim 1 and a car light cluster according to claim 16.

The dependent claims describe preferred or advantageous embodiments of the lighting assembly.

The features and advantages of lighting assembly according to the invention will be apparent from the following description of preferred embodiments thereof, given by way of non-limiting indication, with reference to the accompanying drawings, in which:
- figure 1 is a front view of an example of a lighting assembly according to the invention;
- figure 2 is an enlarged view of the detail in the circle in figure 1;
- figure 3 is an example of a car light cluster, which incorporates the lighting assembly in figure 1;
- figure 4 is an exploded perspective view of the car light cluster;
- figure 5 is a diagrammatic top view of an embodiment of the lighting assembly according to the invention;
- figure 5a is a vertical section view of part of the assembly in figure 5;
- figure 6 is a diagrammatic top view of a further embodiment of the lighting assembly according to the invention;
- figure 7 is a diagrammatic top view of a further embodiment of the lighting assembly according to the invention;
- figures 8 and 8a are diagrammatic top and side views, respectively, of a further embodiment of the lighting assembly according to the invention;
- figure 9 is a diagrammatic top view of a further embodiment of the lighting assembly according to the invention; and
- figure 10 is a diagrammatic top view of a further embodiment of the lighting assembly according to the invention.

The following description refers to a lighting assembly used in a car headlight. However, it is apparent that the lighting assembly of the present invention can be advantageously employed in several applications, possibly with appropriate adaptations, where, due to regulatory constraints, rather than to meet technical or economic requirements, there is a need to generate, either simultaneously or in sequence, a first light effect with a display with an array of point light sources, e.g., mini-LEDs, and a second light effect using a different technology based on one or more light sources coupled to optical structures, e.g., reflectors and/or light guides.

Moreover, in the present disclosure, all directional references (such as upper, lower, upwards, downwards, left, right, to the left, to the right, at the top, at the bottom, above, below, vertical, horizontal, clockwise, and counterclockwise) are used only for identification purposes to help the reader understand the described embodiments and do not create any limitations, in particular as for the position, orientation, or use of the described embodiments.

Conjunction references (such as fixed, coupled, connected, and the like) must be broadly construed and may include intermediate elements between a connection of elements and relative movement between elements. Therefore, the conjunction references do not necessarily imply that two elements are directly connected and in a fixed relationship to each other.

In said drawings, a lighting assembly was indicated by reference numeral 1. The lighting assembly 1 comprises a display 10, an array of first point light sources 12, and at least one optical element 14 placed alongside the display 10.

The first point light sources 12 arranged in an array are suitable for generating a first light effect on the display 10, e.g., a logo, animation, or other information.

The at least one optical element 14 placed alongside the display 10 is suitable for generating a second light effect.

The optical element 14 comprises at least a second light source 16 and at least one optical structure 18 coupled to the at least a second light source 16 and configured to form a plurality of light-emitting points 20 which, when the second light source 16 is activated, generate the second light effect in combination.

According to the invention, the distance between adjacent light-emitting points 20 of at least one portion of the plurality of light-emitting points is substantially uniform and substantially equal to the distance between the first adjacent point light sources 12.

In other words, having defined D1 as the distance between adjacent light-emitting points 20 aligned in a first direction, and having defined P1 as the distance, i.e., the pitch, between two adjacent first light sources 12 of the array, aligned in a direction parallel to the first direction, then D1 is substantially equal to P1.

The term "substantially equal" includes, in addition to equality between such distances or pitches, differences in distance or pitch such that the resulting difference in resolution of the light effect is not perceptible to the human eye. For example, distances or pitches which differ by ±30% may also be substantially equal distances or pitches.

In the following description, for simplicity of disclosure, the light-emitting points 20 which meet the conditions of substantial uniformity and equal mutual distance defined above will also be referred to as "light-emitting points with uniform effect".

Preferably, the optical structure 18 also forms an array of light-emitting points 20.

In this case, in a preferred embodiment, the distance D2 between adjacent light-emitting points 20 aligned in the second direction orthogonal to the first direction is also substantially equal to the distance P2, i.e., the pitch, between two adjacent first light sources 12 of the array, aligned in a direction parallel to the second direction. Therefore, in this case, D2 is also substantially equal to P2.

In an embodiment, the array of the first point light sources 12 is regular, i.e., P1 = P2, and preferably also D1 = D2.

In other words, the light-emitting points 20 with uniform effect are aligned at least along a first direction parallel to the rows or columns of the array of first point light sources 12. Preferably, in the case of optical structure 18 in which the light-emitting points 20 also form an array, the light-emitting points with uniform effect are aligned along both a first direction parallel to the rows of the array of first point light sources 12 and a second direction parallel to the columns of the array of first point light sources 12.

In an embodiment, the first point light sources 12 are mini-LEDs.

For example, the distance between the first light sources 12, and thus between adjacent light-emitting points 20, may range from a few tenths of a millimeter up to 2 mm. For example, in the case of mini-LEDs, such a distance may be 0.8 mm.

In an embodiment, the at least a second light source 16 consists of at least one LED.

In general, in a typical embodiment, the second light sources 16 are made with a different technology than the first light sources 12. For example, while the first point light sources 12 are a mini-LED array mounted to an electronic board assembled to the display 10, the second light sources 16 are LEDs mounted to one or respective electronic printed circuit boards 22 and require the presence of optical systems, e.g., reflectors and/or light guides, to generate a desired light effect, e.g., a light of a car headlight.

By virtue of this different technology, the optical element 14 placed alongside the display 10 typically has a smaller number of second light sources 16 than the number of first light sources 12.

In an embodiment shown in the drawings, the optical element 14 extends from one side of the display 10. For example, the optical element 14 has an elongated shape and has one end adjacent to one side of the display 10.

In order to ensure the effect of uniformity of the overall light effect, the light-emitting points 20 with uniform effect will at least be those located adjacent to the display 10.

The optical structure 18 of the optical element 14 forming the light-emitting points 20 may be made in different configurations and/or combinations of optical components, for example as a function of the technology used, the available space, or regulatory requirements.

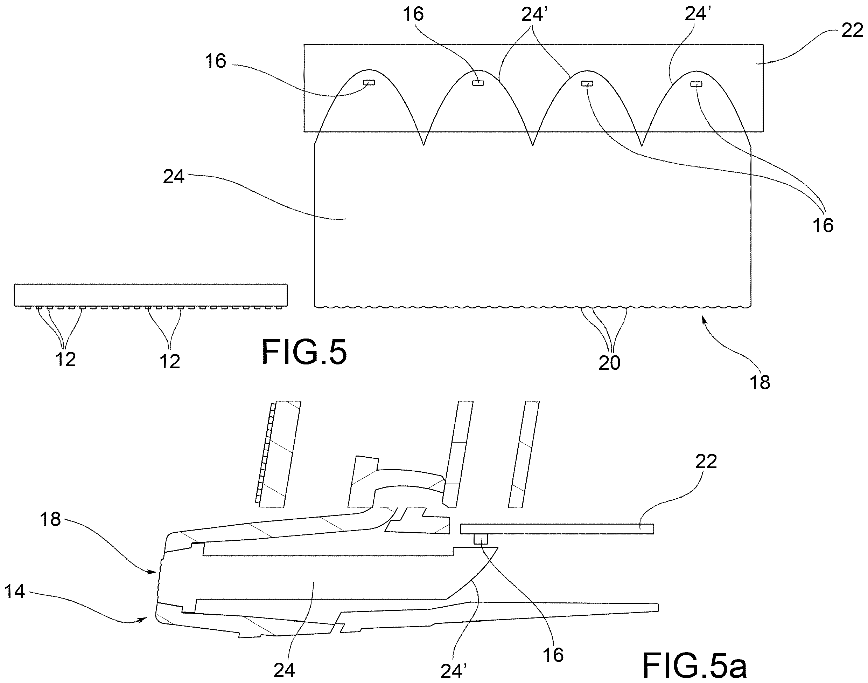

Diagrammatic examples of lighting assemblies, which differ in the configuration of the optical element 14 adjacent to the display 10, and in particular of the optical structure forming the light-emitting points 20 will be provided below with reference to figures 5-10.

In an embodiment, the plurality of light-emitting points 20 is made with a pillow-optic structure 18 with concave or convex lenses. As known, the pillow optics are optical systems forming an array of concave or convex lenses. In this case, the distance D1; D2 between the light-emitting points 20 with uniform effect corresponds to the distance between the centers of adjacent concave or convex lenses.

In the example in figures 5 and 5a, second LED light sources 16 are mounted to an electronic printed circuit board 22 extending on a horizontal plane, thus orthogonally to the light-emitting surface. The second LED light sources are coupled to a light guide 24, which distally forms the pillow-optic structure 18. At its proximal end coupled to the LEDs 16, the light guide 24 forms a series of reflective portions 24', which deflect portions of the light beam from the LEDs 16 towards the pillow-optic structure 18.

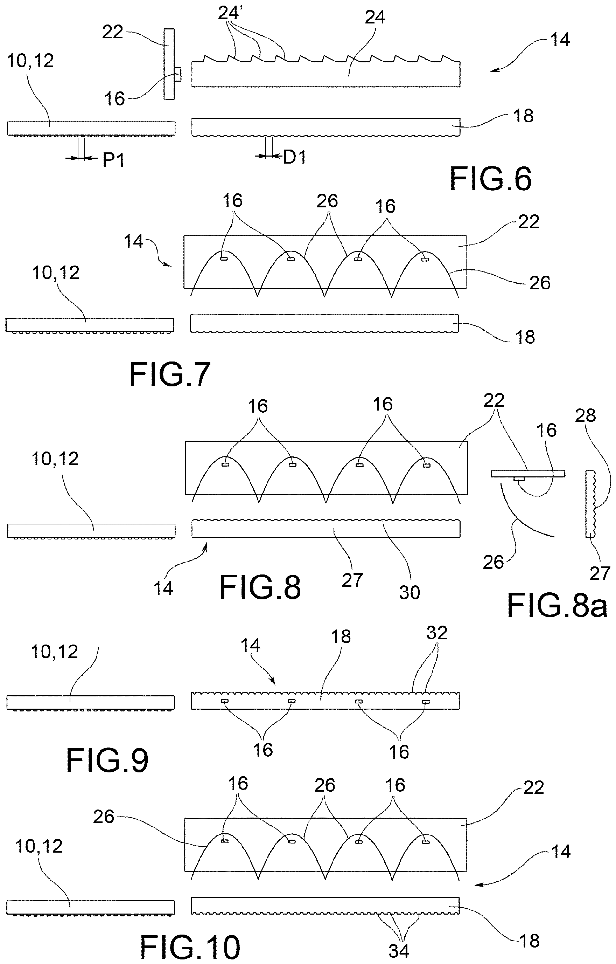

Even in the example in figure 6, one or more second LED light sources 16 are coupled to the pillow-optic structure 18 by means of a light guide 24. In this case, the LEDs 16 are mounted to an electronic printed circuit board 22 extending vertically and laterally with respect to the pillow-optic structure 18. The light guide 24 includes a series of reflective portions 24', for example arranged along a direction parallel to the pillow-optic structure 18, which deflect portions of the light beam from the LEDs 16 towards the pillow-optic structure 18.

In the example in figure 7, the second light source 16 comprises at least one row of LEDs mounted to an electronic printed circuit board 22. Each LED 16 is associated with a respective reflector 26, which reflects all the light produced by the LEDs towards the pillow-optic structure 18.

In the embodiment in figures 8 and 8a, the plurality of light-emitting points 20 is made by superimposing a first horizontally extending parallel-lens optic 28 with a second vertically extending parallel-lens optic 30. In more detail, a transparent or translucent lens body 27 comprises a first face provided with substantially cylindrically extending grooves or reliefs, which define the first horizontally extending parallel-lens optics 28, and a second face provided with substantially cylindrically extending grooves or reliefs, which define the second vertically extending parallel-lens optics 30. The grooves or reliefs arranged substantially perpendicular in the first and second faces 28, 30, respectively, form a sort of pattern of structures with a substantially polygonal base having a defined pitch D1; D2.

Again in this case, the second light source 16 comprise at least one row of LEDs mounted to an electronic printed circuit board 22, in which each LED is associated with a respective reflector 26 which reflects all the light produced by the LEDs towards the lens body 27.

In an embodiment shown in figure 9, the optical structure 18 forming the plurality of light-emitting points 20 is made with a light guide bar containing microstructures 32 suitable for scattering the light emitted by the sources 16 and having a distance between the center of one microstructure 32 and the center of the adjacent one equal to the pitch between adjacent mini-LEDs 12 of the display 10 and one adjacent thereto.

In an embodiment shown in figure 10, the plurality of light-emitting points 20 is made with an optical structure 18 defining scattering (or diffusive) centers 34. In this case, the distance between the light-emitting points with uniform effect corresponds to the distance between the scattering centers.

Again in this example, the second light source 16 comprises at least one row of LEDs mounted to an electronic printed circuit board 22, where each LED is associated with a respective reflector 26 which reflects all the light produced by the LEDs towards the optical structure 18.

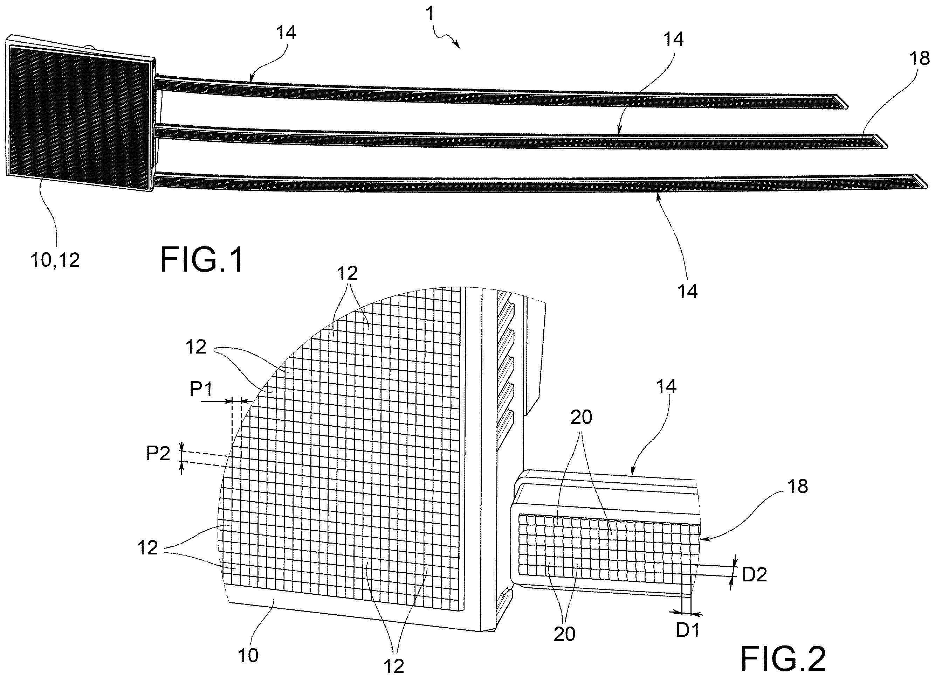

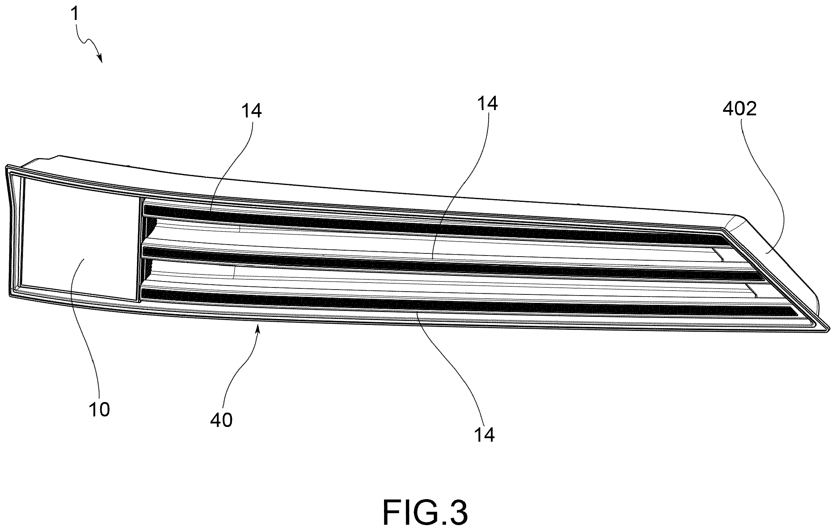

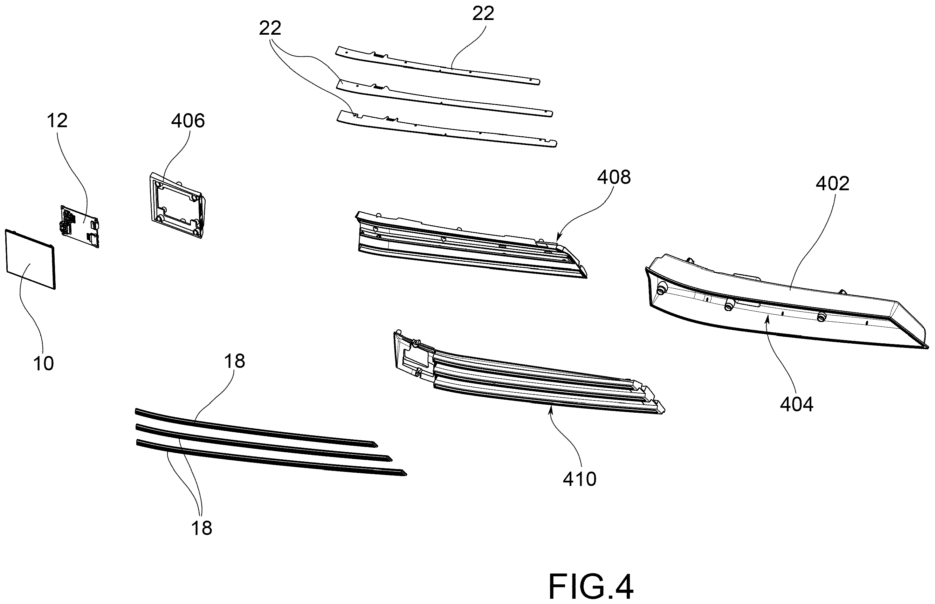

Turning back to figures 3 and 4, the lighting assembly 1 in figures 1 and 2 is shown installed in a car headlight 40.

In particular, figure 4 shows an headlight body 402 defining an headlight compartment 404 which houses the lighting assembly 1. The display 10 and the electronic board behind it, to which the mini-LED array 12 is mounted, are supported by a display support frame 406.

Three elongated optical elements 14 vertically spaced apart from one another extend from one side of the display 10, in a substantially horizontal direction.

Each optical element 14 comprises a respective LED board 22, i.e., an electronic printed circuit board to which a plurality of LEDs is mounted. Each optical element 14 further comprises a pillow-optic structure 18 from which the light generated by the LEDs 16 of a respective LED board 22 is emitted. The pillow-optic structure 18 forms the light-emitting points 22 having a substantially uniform mutual distance equal to the pitch of the mini-LED array 12.

The LED boards 22 and the pillow-optic structures 18 are supported by a frame assembly 408, 410, consisting of two parts assembled together and to the light cluster body 402. The frame assembly 408, 410 also forms reflector elements suitable for directing the light beam generated by the LEDs to the pillow-optic structure 18.

The lighting assembly described above thus allows generating lighting effects that, although produced by lighting devices placed side-by-side and manufactured with different technologies, are homogeneous, uniform, and seamless. In particular, uniformity in terms of luminance is created between the emitting surfaces of the display and the adjacent optical structure.

In particular, the optical structure of each optical element placed alongside the mini-LED array display, by virtue of the choice of the distance between the respective lenses forming respective light-emitting points, equal to the pitch of the mini-LED array, allows simulating the effect produced by a mini-LED array having the same pitch as the actual adjacent mini-LED array, even if the light extracted from the optical structure is generated by only one light source, such as an LED, or by a smaller number of light sources than the number of light-emitting points.

Those skilled in the art may make changes and adaptations to the embodiments of the lighting assembly and the car headlight according to the invention or may replace elements with others which are functionally equivalent in order to meet contingent needs without departing from the of the appended claims. Each of the features described above as belonging to a possible embodiment may be implemented irrespective of the other embodiments described.

## Claims

1. A lighting assembly (1), in particular for a car headlight (40), comprising a display (10), an array of first point light sources (12) suitable for generating a first light effect on the display (10), and at least one optical element (14) placed alongside the display (10) and suitable for generating a second light effect, wherein the optical element (14) comprises at least a second light source (16) and at least one optical structure (18) coupled to the at least a second light source (16) and configured to form a plurality of light-emitting points (20) which, when the second light source (16) is activated, generate the second light effect in combination,
wherein the distance (D1; D2) between adjacent light-emitting points (20) of at least one portion of said plurality of light-emitting points is substantially uniform and substantially equal to the distance (P1; P2) between the first point light sources (12).

2. Assembly according to claim 1, wherein the first point light sources (12) are mini-LEDs.

3. Assembly according to claim 1 or 2, wherein the at least a second light source (16) consists of at least one LED.

4. Assembly according to any one of the preceding claims, wherein the optical element (14) extends from one side of the display (10).

5. Assembly according to any one of the preceding claims, wherein the light-emitting points (20) of said portion of the plurality of light-emitting points are aligned at least along a first direction parallel to the rows or columns of the array of first point light sources (12) .

6. Assembly according to any one of the preceding claims, wherein the plurality of light-emitting points (12) is made with a pillow-optic structure (18) with concave or convex lenses.

7. Assembly according to any one of claims 1-5, wherein the plurality of light-emitting points (20) is made by superimposing a first horizontally extending parallel-lens optic (28) with a second vertically extending parallel-lens optic (30).

8. Assembly according to any one of claims 1-5, wherein the plurality of light-emitting points (20) is made with an optical structure (18) defining scattering centers (32) .

9. Assembly according to any one of the preceding claims, wherein the optical element (14) comprises a plurality of second light sources (16) suitable for illuminating the optical structure (18).

10. Assembly according to claim 9, wherein each second light source (16) is coupled to the optical structure (18) by means of a respective reflector element (26).

11. Assembly according to claim 9, wherein each second light source (16) is coupled to the optical structure (18) by means of a respective light guide (24).

12. Assembly according to any one of claims 1-8, wherein the optical element (14) comprises a second light source (16) suitable for illuminating at least one portion of the optical structure (18) by means of a light guide (24) .

13. Assembly according to claim 12, wherein said light guide (24) is provided with a plurality of reflector elements (25'), each suitable for reflecting a respective portion of the light beam from the second light source (16) towards the optical structure (18).

14. Assembly according to claim 12 or 13, wherein the optical structure (18) is obtained in the light guide (24), at a distal end thereof.

15. Assembly according to any one of the preceding claims, wherein the at least a second light source (16) is mounted to an electronic printed circuit board (22).

16. A car headlight (40), comprising a lighting assembly (1) according to any one of the preceding claims.
